# EUROPEAN PATENT APPLICATION

(11) **EP 3 626 903 A1**
(43) Date of publication of application: **25.03.2020**
(21) Application number: 17909975.9
(22) Date of filing: 05.09.2017
(51) Int. Cl.: E04D 3/35, E04D 13/18, H01L 31/042

(54) **ROOF TILE WITH A PHOTOVOLTAIC CELL**

(30) Priority: 19.05.2017 RU 2017117439
(71) Applicant: Limited Liability Company "Thermotile", Moscow 121205 (RU)
(72) Inventor: BESPYATY, Anatoly Vladimirovich, Moscow 125080 (RU); EVSTEGNEEV, Kirill Viktorovich, Moscow 125445 (RU)
(74) Representative: Berggren Oy, Helsinki & Oulu
(86) International application number: PCT/RU2017/000647
(87) International publication number: WO 2018/212675

(57) **Abstract**

The invention relates to construction, in particular to a special tile, which provides thermal and heat insulation, not harmful to the environment, accumulates solar energy and generates electrical energy, and which can be used in the construction of roof coverings for roofs of industrial and public buildings and structures. A roof tile comprises an upper protective layer, under which a photovoltaic cell is mounted, wherein the upper protective layer is formed from polyethylene terephthalate, and the following are arranged consecutively under the photovoltaic cell: a heat-insulating and sound-insulating layer made from polyurethane foam, a cardboard layer, a technical layer formed from highpressure polyethylene and a lower protective layer formed from polyethylene terephthalate with a metallized base. The metallized base is formed from aluminium. The upper protective layer is made transparent to allow solar energy to pass to the photovoltaic cell.

## Description

### TECHNICAL FIELD

The present disclosure relates to construction, namely to the special tile providing heat and heat insulation, not harmful to the environment, accumulating solar and generating electrical energy and can be used in the construction of industrial and public buildings structures roofing.

### BACKGROUND

Conventionally, there is known Solar Photovoltaic Panels to be fixed on roofing tiles (see [1] US2016164453, IPC H01L31/048, publ. 06/09/2016; [2] RF patent No. 2557272, IPC E04D13/18, publ. 20.07.2015). Disadvantage of the analogs is the possibility of damaging the solar panels when fixing it on a tile and complexity of the mounting - first you have to fix tile on the roof and only then install the panels. Also, one must take into consideration formation of cavities between photocell and roofing.

The best way to layout a roof with solar panels is to make tile-pieces with photocells already at the stage of production. Thus, in the related technologies, tile-pieces with built-in photocells are known (see [3] WO2015135126, IPC E04D1/02, publ. 17.09.2015; [4] KR20140114541, IPC E04D1/16, publ. 29.09.2014; [5] CN203452283, IPC E04D1/28, publ. 26.02.2014; [6] TWM466143, IPC E04D13/18, publ. 21.11.2013; [7] CN102912946, IPC E04D13/18, publ. 06.02.2013; [8] US2013180575, IPC H01L31/048, publ. 18.07.2013; [9] DE102012008852, IPC E04D1/04, publ. 07.11.2013; [10] WO2012078491, IPC E04D1/08, publ. 14.06.2012). Common drawback of the above analogs is the loss of heat and sound-insulation properties in production of a tile-piece with a photocell (solar panel), because main attention is paid to the electricity gain from the sun beam energy, and not to maintain the roof tiles prime performance characteristics.

The closest analogous solution in terms of totality of essential features is the so-called solar tile (see [11] Hungarian patent HU227066, IPC E04D13/18, H01L31/04, publ. 28.06.2010), the outer surface of which is equipped with solar cells, and solar batteries are equipped with wires and connectors.

Drawbacks of the prototype are similar to the earlier analogues, that is: loss of heat and sound-insulation properties in production of a tile-piece with a photocell (solar panel), because main attention is paid to the electricity gain from the sun beam energy, and not for maintaining the roof tiles prime performance characteristics. The main disadvantage of such analogs is complexity of mounting of the photocell, lack of reflective insulation on the back side of the roofing, overlapping of the protective layers, one layer protects a photocell and another layer protects the roof itself from water, sun and moisture.

### SUMMARY

The object of the claimed invention is to provide a roof covering allowing to protect attic rooms from over-heating in summer and cooling in winter, in a private pitched housing construction, while maintaining the classic shape, while converting solar energy into electric energy.

The effect of the claimed invention is an increase in the thermal insulation and soundproof properties of tile-pieces while receiving electricity.

The effect is achieved due to the fact that the roof tile comprises an upper protective layer under which a photocell is mounted, a heat and sound insulating layer made of a polyurethane foam, a cardboard layer, a technical layer made of high-density polyethylene and a lower protective layer made of polyethylene terephthalate with a metallized base, wherein the heat and sound insulation layer, the cardboard layer, the technical layer and the lower protective layer are sequentially located under the photocell, and the upper protective layer is made of polyethylene terephthalate.

Also, the effect is achieved due to the use of aluminum as a metallized base.

Also, the effect is achieved due to the fact that the upper protective layer is made transparent, for the solar energy to reach the photocell.

### BRIEF DESCRIPTION OF THE DRAWINGS

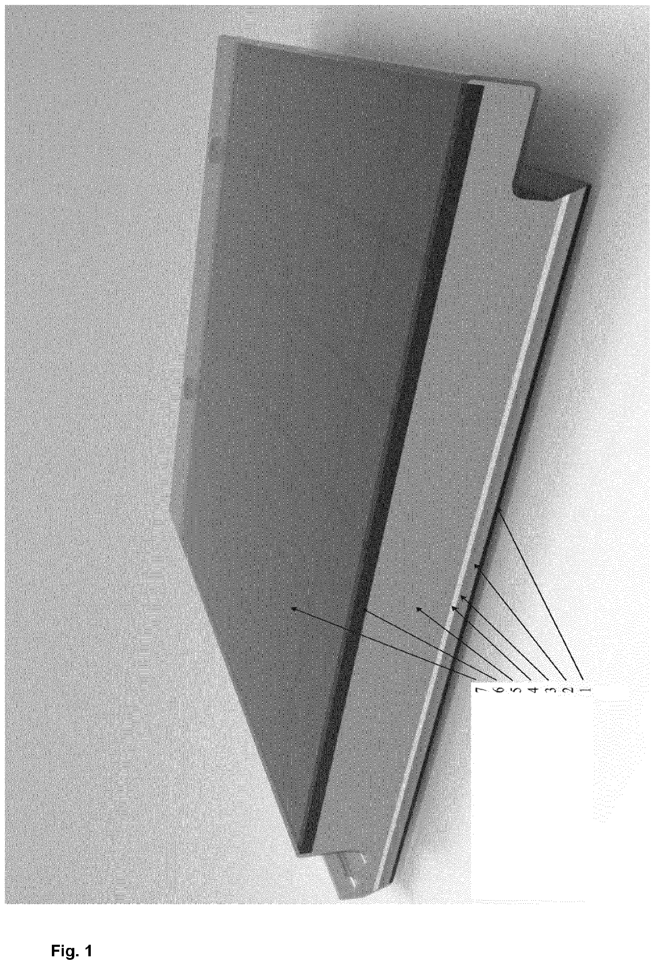

Fig. 1 shows a sectional view of a multi-layered roof tile-piece with a photocell.

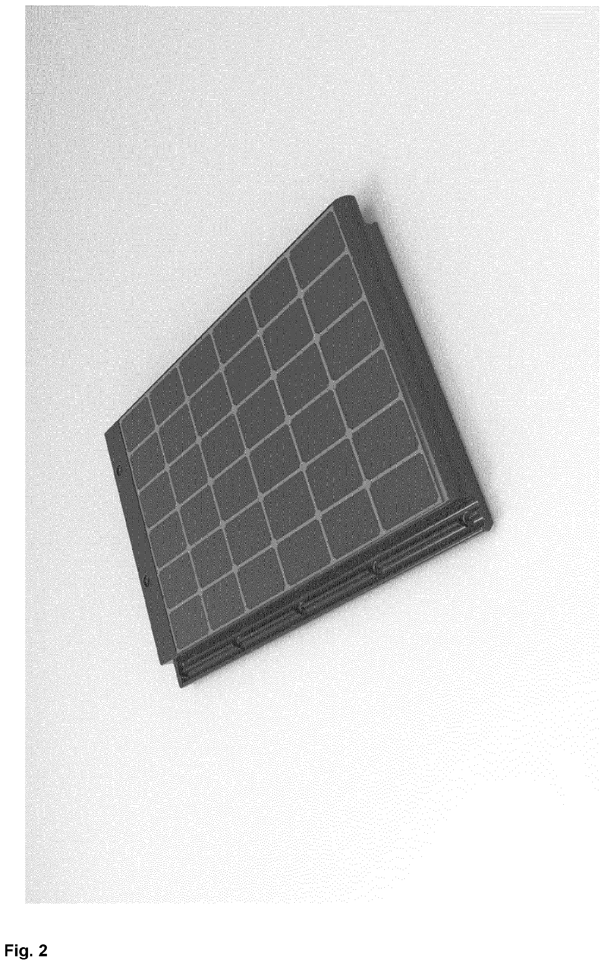

Fig. 2 shows a general view of the tile with a photocell.

The following items are presented in the Figures:
*1 - metallized base;*
*2 - lower protective layer made of polyethylene terephthalate;*
*3 - technical layer made of high-density polyethylene;*
*4 - cardboard layer;*
*5 - heat and sound insulation inner layer made of polyurethane foam;*
*6 - photocell;*
*7 - upper protective layer made of polyethylene terephthalate.*

### DETAILED DESCRIPTION OF THE INVENTION

In one embodiment the roofing tile contains a lower protective layer (2) made of polyethylene terephthalate with a metallized base (1) made of aluminum. The lower protective layer (2), serving also as a substrate for metallization, protects against mechanical damage, and the metallized base (1) applied on it reflects infrared radiation back inside the house (premises).

The technical layer (3) made of high-density polyethylene is laid on the lower protective layer, and cardboard layer (4) is laid-out on it. Heat and sound insulating inner layer made of polyurethane foam (5) is laid-out over the cardboard layer (4). Cardboard layer (4) absorbs the two-component polyurethane foam, thereby increasing adhesion to the high-density polyethylene layer (3), which in turn bonds together the cardboard layer and the lower protective layer (2).

A photocell (6) with an upper protective layer (7) of polyethylene terephthalate is placed on top of the heat and sound insulating inner layer (5). The upper protective layer (7) is made transparent to allow solar energy to pass to the photocell (6). Any known photoconverters (solar panels) can be used as a photocell. Note that the layer (7) is resistant to corrosion, mold and fungus do not grow on it, protects from external mechanical impacts, thereby increasing thermal insulation and soundproof properties. At the same time, a protective layer made of polyethylene terephthalate makes it possible to give the roofing a classical look of a piece of roofing material - tiles.

Use of non-hygroscopic heat-insulating material of polyurethane foam in the form of heat and sound insulation layer (5), which at the time of foaming and polymerization has strong adhesive properties, allows reliable connecting (bonding) the upper (7) and lower (2) protective layers of polyethylene terephthalate, strengthened by technical (3) and cardboard (4) layers.

Polymerized polyurethane foam, filling the entire internal volume of the product, provides rigidity to the resulting structure, which allows the roofing to withstand high loads (for example, when walking on the roof).

The inner layer (5) of two-component polyurethane foam assures low thermal conductivity of the product, high noise absorption, as well as filling the entire internal volume of the product, increasing its rigidity, thereby protecting the photocell.

## Claims

1. A roof tile comprising an upper protective layer under which a photocell is mounted, a heat and sound insulating layer made of a polyurethane foam, a cardboard layer, a technical layer made of high-density polyethylene and a lower protective layer made of polyethylene terephthalate with a metallized base, wherein the heat and sound insulation layer, the cardboard layer, the technical layer and the lower protective layer are sequentially located under the photocell, and the upper protective layer is made of polyethylene terephthalate.

2. The roofing tile according to claim 1, wherein the metallized base is made of aluminum.

3. The roofing tile according to claim 1, wherein the upper protective layer is made transparent to allow solar energy to pass to the photocell.
